# EUROPEAN PATENT APPLICATION

(11) **EP 0 836 219 A2**
(43) Date of publication of application: **15.04.1998**
(21) Application number: 97307875.1
(22) Date of filing: 06.10.1997
(51) Int. Cl.: H01J 37/34, H01J 37/32

(54) **Active shield for generating a plasma for sputtering**

(30) Priority: 08.10.1996 US 730722; 30.01.1997 US 791278
(71) Applicant: APPLIED MATERIALS, INC., Santa Clara, California 95054-3299 (US)
(72) Inventor: Yao, Gongda, Fremont, California 94539 (US); Hofmann, Ralf, San Jose, California 95129 (US); Tepman, Avi, Cupertino, California 95014 (US); Gopalraja, Praburam, Sunnyvale, California 94089 (US)
(74) Representative: Bayliss, Geoffrey Cyril

(57) **Abstract**

A plasma chamber (100) in a semiconductor fabrication system eliminates the need for magnetron sputtering.

Referring first to Figs. 1-2, a plasma generator in accordance with an embodiment of the present invention comprises a substantially cylindrical plasma chamber (100) which is received in a vacuum (102) (Fig.2). The plasma chamber (100) of this embodiment has a single turn helical coil (104) which is carried internally of the vacuum chamber walls (108) (Fig.2) by a chamber shield (106). The chamber shield (106) protects the interior walls (108) (Fig.2) of the vacuum chamber (102) from the material being deposited within the interior of the plasma chamber (100).

Radio frequency (RF) energy from an RF generator (404) is radiated from the coil (104) into the interior of the plasma chamber (100), which energizes a plasma within the plasma chamber (100). An ion flux strikes a negatively biased, magnetron-free target (110) positioned above the plasma chamber (100). No magnetron magnets are disposed above the magnetron-free target (110). The plasma ions eject material from the magnetron-free target (110) onto a substrate (112) which may be a wafer or other workpiece supported by a pedestal (114) at the bottom of the plasma chamber. It has been found that high density plasmas produce sufficient ionization to provide for a high deposition rate of target material onto a substrate, which allows for the elimination of magnetron magnetic fields and the attendant magnetron magnets. By eliminating the magnetron, the uniformity of the deposition of target material onto a workpiece can also be improved. In addition, the sidewall coverage of trench-like structures and contact holes and the like can also be increased. Furthermore, the rate of the deposition of target material onto a workpiece can be the same or better than that obtainable using magnetron sputtering.

## Description

The present invention relates to plasma generators, and more particularly, to a method and apparatus for generating a plasma to sputter deposit a layer of material in the fabrication of semiconductor devices.

Low pressure plasmas have become convenient sources of energetic ions and activated atoms which can be employed in a variety of semiconductor device fabrication processes including surface treatments, depositions, and etching processes. For example, to deposit materials onto a semiconductor wafer using a sputter deposition process, a plasma is produced in the vicinity of a sputter target material which is negatively biased and which is subjected to magnetron magnetic fields produced by magnets positioned adjacent the target. Electrons created within the plasma travel in generally helical paths around the magnetron magnetic fields in the vicinity of the target, creating ions within the plasma that impact the surface of the target to dislodge, i.e., "sputter" material from the target. The sputtered materials are then transported and deposited on the surface of the semiconductor wafer. The magnetron magnets are typically permanent magnets, which are mechanically moved across the back surface of the target to promote more uniform erosion of the target material from the target surface. Electromagnets have also been used for magnetrons. Whether the magnetic fields of the magnetron are produced by permanent magnets or by electromagnetic coils, providing the magnetron magnetic fields adds measurably to the cost and complexity of conventional plasma sputtering devices.

Sputtered material has a tendency to travel in straight line paths, from the target to the substrate being deposited, at angles which are oblique to the surface of the substrate. As a consequence, materials deposited in etched trenches and holes of semiconductor devices having trenches or holes with a high depth to width aspect ratio, can bridge over causing undesirable cavities in the deposition layer. To prevent such cavities, the sputtered material can be redirected into substantially vertical paths between the target and the substrate by negatively charging the substrate if the sputtered material is sufficiently ionized by the plasma. However, material sputtered by a low density plasma often has an ionization degree of less than 1% which is usually insufficient to avoid the formation of an excessive number of cavities. Accordingly, it is desirable to increase the density of the plasma to increase the ionization rate of the sputtered material in order to decrease the formation of unwanted cavities in the deposition layer. As used herein, the term "dense plasma" is intended to refer to one that has a high electron and ion density.

There are several known techniques for exciting a plasma with RF fields, including capacitive coupling, inductive coupling and wave heating. In a standard inductively coupled plasma (ICP) generator, RF current passing through a coil surrounding the plasma induces electromagnetic currents in the plasma. These currents heat the conducting plasma by ohmic heating, so that it is sustained in steady state. As shown in U.S. Pat. No. 4,362,632, for example, current through a coil is supplied by an RF generator coupled to the coil through an impedance-matching network, such that the coil acts like the first windings of a transformer. The plasma acts like a single turn second winding of a transformer.

A high density plasma typically requires the chamber to be operated at a relatively high pressure. As a result, the frequency of collisions between the plasma ions and the deposition material atoms is increased and the scattering of the deposition atoms is likewise increased. This scattering of the deposition atoms typically causes the thickness of the deposition layer on the substrate to be thicker on that portion of the substrate aligned with the center of the target and thinner in the outlying regions.

It is an object of the present invention to provide an improved method and apparatus for generating a plasma within a chamber and for sputter-depositing a layer which obviate, for practical purposes, the above-mentioned limitations.

These and other objects and advantages are achieved by, in accordance with one aspect of the invention, a plasma generating apparatus which eliminates the need for magnetrons when sputtering. It has been found that high density plasmas can produce sufficient ionization to provide for a high deposition rate of target material onto a workpiece and thereby eliminate the need for magnetron magnetic fields and the attendant magnetron magnets. By eliminating the magnetron, the uniformity of the deposition of target material onto a workpiece can also be improved. In addition, the sidewall coverage of trench-like structures and contact holes and the like can also be increased. Furthermore, the rate of the deposition of target material onto a workpiece can be the same or better than that obtainable using magnetron sputtering.

In a preferred embodiment, an apparatus for energizing a plasma within a semiconductor fabrication system to sputter material onto a workpiece may include a semiconductor fabrication chamber having a magnetron-free target and a plasma generation region adjacent the target. A single turn coil carried by the chamber is positioned to couple energy into the plasma generation region, to produce ions to strike the target obviating the need for magnetron magnetic fields to produce ions for sputtering material from the target onto the workpiece. As a consequence, substantially all the ions striking the target are produced by the RF energy coupled into the plasma generation region by the coil. The target and coil may both include titanium, aluminum or other suitable materials. Alternatively, a secondary annular target may be positioned around the periphery of the workpiece, to supplement the material being sputtered from a primary planar target onto the workpiece, with the primary planar target being positioned above the workpiece.

The following is a description of some specific embodiments of the invention, reference being made to the accompanying drawings, in which:

Fig. 1 is a perspective, partial cross-sectional view of a plasma generating chamber in accordance with an embodiment of the present invention.

Fig. 2 is a partial cross-sectional view of the plasma generating chamber of Fig. 1 shown installed in a vacuum chamber.

Fig. 3 is a schematic diagram of the electrical interconnections to the plasma generating chambers of Figs. 1-2.

Fig. 4 is a schematic diagram of alternative electrical interconnections to the plasma generating chambers of Figs. 1-2.

Fig. 5 is a schematic cross-sectional view of a workpiece with target material deposited thereon using conventional magnetron sputtering.

Fig. 6 is a schematic cross-sectional view of a workpiece with target material deposited thereon in accordance with another aspect of embodiments of the present invention.

Fig. 7 is a perspective view of a coil ring for a plasma generating apparatus in accordance with another aspect of embodiments of the present invention.

Fig. 8 is a chart depicting the respective deposition profiles for material deposited in accordance with yet another aspect of embodiments of the present invention.

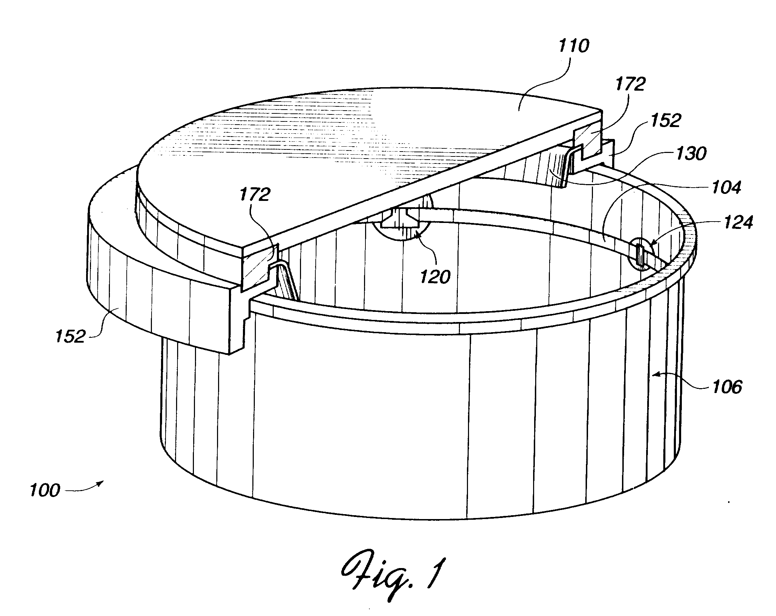

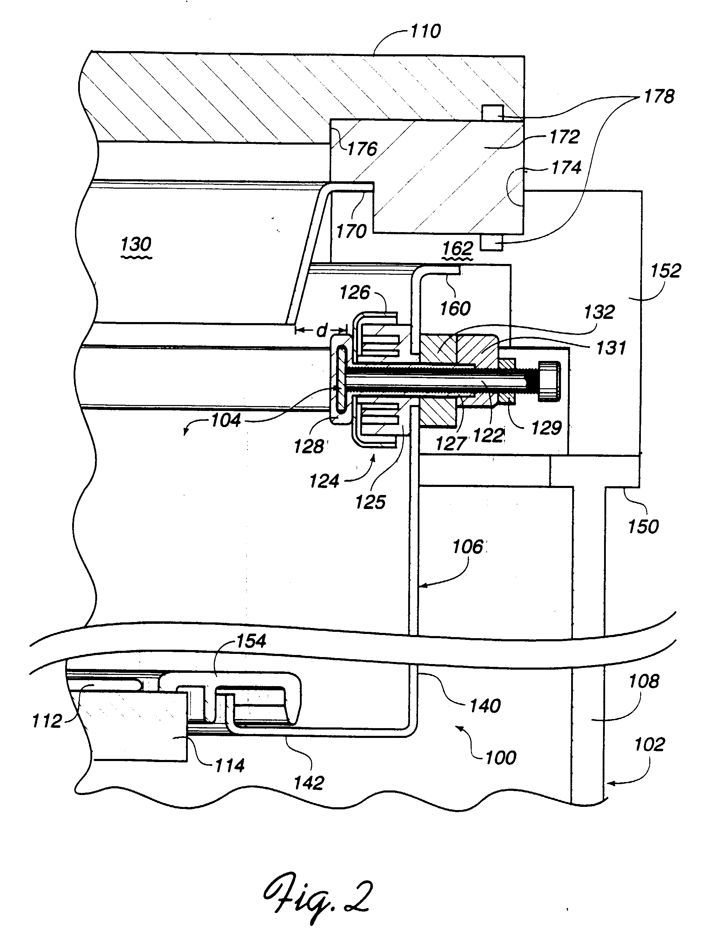

Referring first to Figs. 1-2, a plasma generator in accordance with an embodiment of the present invention comprises a substantially cylindrical plasma chamber 100 which is received in a vacuum chamber 102 (Fig. 2). The plasma chamber 100 of this embodiment has a single turn helical coil 104 which is carried internally of the vacuum chamber walls 108 (Fig. 2) by a chamber shield 106. The chamber shield 106 protects the interior walls 108 (Fig. 2) of the vacuum chamber 102 from the material being deposited within the interior of the plasma chamber 100.

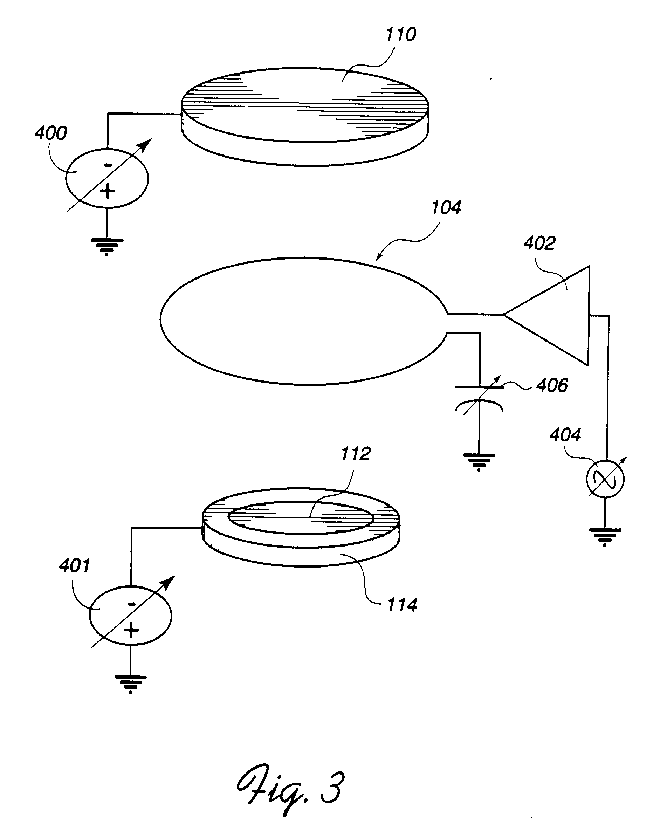

Radio frequency (RF) energy from an RF generator 404 (shown schematically in Figs. 3-4) is radiated from the coil 104 into the interior of the plasma chamber 100, which energizes a plasma within the plasma chamber 100. As will be explained in greater detail below, in accordance with one aspect of the present invention, an ion flux strikes a negatively biased, magnetron-free target 110 positioned above the plasma chamber 100. No magnetron magnets are disposed above the magnetron-free target 110. The plasma ions eject material from the magnetron-free target 110 onto a substrate 112 which may be a wafer or other workpiece supported by a pedestal 114 at the bottom of the plasma chamber 100. It has been found that high density plasmas produce sufficient ionization to provide for a high deposition rate of target material onto a substrate 112, which allows for the elimination of magnetron magnetic fields and the attendant magnetron magnets.

Material may also be sputtered from the coil 104 onto the substrate 112 to supplement the material which is being sputtered from the magnetron-free target 110 onto the workpiece. As a result, the layer deposited onto the substrate 112 may be formed from material from both the coil 104 and the magnetron-free target 110 which can substantially improve the deposition uniformity of the resultant layer.

The coil 104 is carried on the chamber shield 106 by a plurality of coil standoffs 120 (Fig. 1) which electrically insulate the coil 104 from the supporting chamber shield 106. As set forth in copending application Serial No. 08/647,182, entitled RECESSED COIL FOR GENERATING A PLASMA, filed May 9, 1996 (Attorney Docket # 1186/PVD/DV) and assigned to the assignee of the present application, which application is incorporated herein by reference in its entirety, the insulating coil standoffs 120 have an internal labyrinth structure which permits repeated deposition of conductive materials from the magnetron-free target 110 onto the coil standoffs 120 while preventing the formation of a complete conducting path of deposited material from the coil 104 to the chamber shield 106 which could short the coil 104 to the chamber shield 106 (which is typically grounded).

RF power is applied to the coil 104 by feedthrough bolts 122 (Fig. 2) which are supported by insulating feedthrough standoffs 124. As set forth in the aforementioned copending application Serial No. 08/647,182, entitled RECESSED COIL FOR GENERATING A PLASMA, the feedthrough standoffs 124, like the coil support standoffs 120, permit repeated deposition of conductive material from the target onto the feedthrough standoff 124 without the formation of a conducting path which could short the coil 104 to the chamber shield 106. The coil feedthrough standoff 124 includes a generally disk-shaped base member 125 which is preferably made of an insulative dielectric material such as a ceramic. Covering and shielding the base member 125 is a generally cylindrically shaped cover member 126 which is preferably made of the same material which is being deposited. Hence, if the material being deposited is made of titanium, the cover member 126 is preferably made of titanium as well. To facilitate adherence of the deposited material (here for example, titanium), it is preferable to treat the surface of the metal by bead blasting which will reduce flaking off and shedding of particles of the deposited material. The feedthrough standoff 124 also has a central aperture through which extends the threaded conductive feedthrough bolt 122 through which RF power is applied to the coil 104. The feedthrough bolt 122 is received by a titanium sleeve 127 which has a termination sleeve 128 of bead-blasted titanium which receives the coil 104. The feedthrough standoff 124 is secured to the wall 140 of the chamber shield 106 by the insulative base member 125 on the interior side of the wall 140 and a nut 129 threaded onto the feedthrough bolt 122 on the other side of the wall 140. The nut 129 is spaced from the wall 140 by a connector 131 and an insulative spacer 132. The electrical connector 131 connects the feedthrough bolt 122 to the RF generator 404 (Figs. 3-4) through a matching network 402 (also shown schematically in Figs. 3-4).

As set forth in the aforementioned copending application Serial No. 08/647,182, entitled RECESSED COIL FOR GENERATING A PLASMA, the feedthrough standoff 124 also has an internal labyrinth structure somewhat similar to that of the coil standoff 120. This internal labyrinth structure prevents the formation of a short between the coil 104 and the wall 140 of the chamber shield 106.

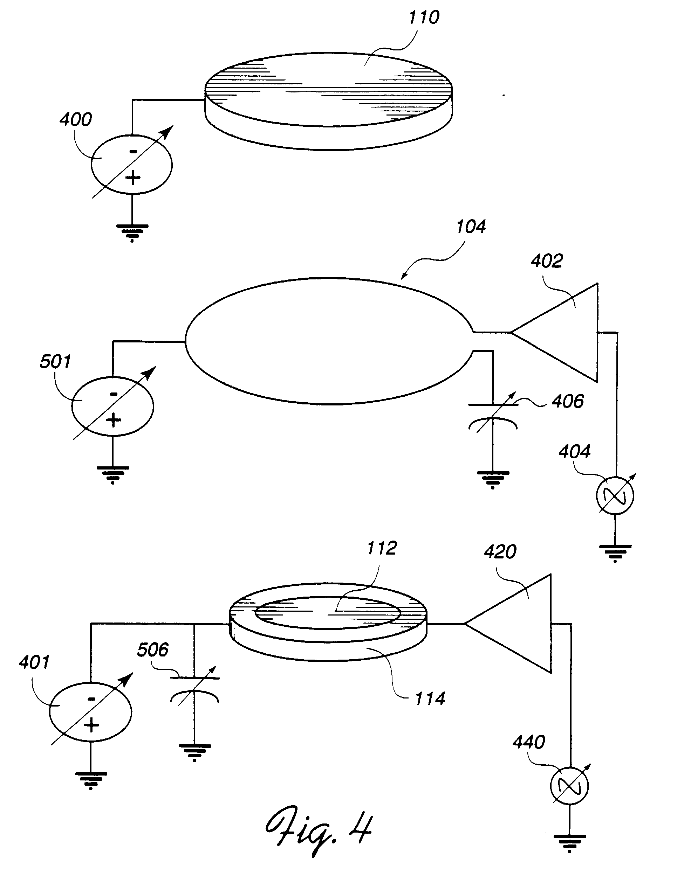

Fig. 3 is a schematic representation of the electrical connections of the plasma generating apparatus of this illustrated embodiment. To attract the ions generated by the plasma, the magnetron-free target 110 is preferably negatively biased by a variable DC power source 400. In the same manner, the pedestal 114 may be negatively biased by a variable DC power source 401 to bias the substrate 112 negatively to attract the ionized deposition material to the substrate 112. In an alternative embodiment, as shown in Fig. 4, the pedestal 114 may also be biased by a high frequency RF power source, in addition to the negative DC offset biasing of the pedestal 114 by the variable DC power source 401, so as to attract the ionized deposition material more uniformly to the substrate 112. In this alternative embodiment, one end of the pedestal 114 may be coupled to an RF source such as the output of an amplifier and matching network 420, the input of which is coupled to an RF generator 440, while the other end of the pedestal 114 is coupled to ground, preferably through a capacitor 506, which may be a variable capacitor, and also through a variable DC power source 401. For example, the external negative DC offset biasing of the pedestal 114 by the variable DC power source 401 may negatively bias the pedestal 114 and substrate 112 to about -30 V relative to the ground, which would then be the mean value of the biasing when the pedestal 114 is coupled to the RF source, such as the output of the amplifier and matching network 420, the input of which is coupled to the RF generator 440. External biasing of the pedestal 114 and the substrate 112 of greater than about 50 V in absolute value, relative to the ground, should be avoided in order to decrease sputtering (and resputtering) of the substrate 112.

As set forth in copending application Serial No. 08/677,588, entitled A METHOD FOR PROVIDING FULL-FACE HIGH DENSITY PLASMA PHYSICAL VAPOR DEPOSITION, filed July 9, 1996 (Attorney Docket # 1402/PVD/DV) and assigned to the assignee of the present application, which application is incorporated herein by reference in its entirety, an external biasing of the pedestal 114 and the substrate 112 may be omitted, in another alternative embodiment. For example, the substrate 112 may develop a self-biasing of between about -5 V to about -10 V relative to the ground, even in the absence of any external biasing.

As shown in Fig. 3, one end of the coil 104 may be coupled to an RF source such as the output of an amplifier and matching network 402, the input of which is coupled to an RF generator 404. The other end of the coil 104 may be coupled to ground, preferably through a capacitor 406, which may be a variable capacitor. Alternatively, as shown in Fig. 4, the coil 104 may also be biased, positively or negatively, by a variable DC power source 501. The coil 104 may be biased positively by the variable DC power source 501 to repel the ionized deposition material away from the coil 104. Alternatively, the coil 104 may be biased negatively by the variable DC power source 501 to attract the ionized deposition material to the coil 104. For example, the external positive DC offset biasing of the coil 104 by the variable DC power source 501 may positively bias the coil 104 to about +20 V relative to the ground, which would then be the mean value of the biasing when the coil 104 is coupled to the RF source, such as the output of the amplifier and matching network 402, the input of which is coupled to the RF generator 404.

Fig. 2 shows the plasma chamber 100 installed in the vacuum chamber 102 of a physical vapor deposition (PVD) system. Although the plasma generator of the present invention is described in connection with a PVD system for illustration purposes, it should be appreciated that a plasma generator in accordance with the present invention is suitable for use with other semiconductor fabrication processes utilizing a plasma, including plasma etch, chemical vapor deposition (CVD) and various surface treatment processes.

As best seen in Fig. 2, the plasma chamber 100 of this embodiment has a dark space shield ring 130 which provides a ground plane with respect to the magnetron-free target 110 above, which is negatively biased. In addition, as explained in greater detail in the aforementioned copending application Serial No. 08/647,182, entitled RECESSED COIL FOR GENERATING A PLASMA, the shield ring 130 shields the outer edges of the target from the plasma to reduce sputtering of the target outer edges. The dark space shield 130 performs yet another function in that it is positioned to shield the coil 104 (and the coil support standoffs 120 and feedthrough standoffs 124) from the material being sputtered from the magnetron-free target 110.

In this illustrated embodiment, the dark space shield 130 is a closed continuous ring of (diamagnetic) titanium or (non-ferromagnetic) stainless steel or (non-magnetic) nickel having a generally inverted frusto-conical shape. The dark space shield extends inward toward the center of plasma chamber 100 so as to overlap the coil 104 by a distance d of about 1/4 inch. It is recognized, of course, that the amount of overlap can be varied depending upon the relative size and placement of the coil 104 and other factors. For example, the overlap may be increased to increase the shielding of the coil 104 from the sputtered material, but increasing the overlap could also further shield the magnetron-free target 110 from the plasma which may be undesirable in some applications. Alternatively, the amount of overlap between the dark space shield 130 and the coil 104 may be decreased by moving the coil 104 closer in toward the center of plasma chamber 100 so as to increase the energization of the high density plasma.

The chamber shield 106 is generally bowl-shaped and includes a generally cylindrically shaped, vertically oriented wall 140 to which the standoffs 120 and 124 are attached to insulatively support the coil 104. The shield further has a generally annular-shaped floor wall 142 which surrounds the chuck or pedestal 114 which supports the substrate 112 which has about an 8" diameter (about 200 mm) in the illustrated embodiment. A clamp ring 154 clamps the wafer to the chuck 114 and covers the gap between the floor wall 142 of the chamber shield 106 and the chuck 114. Thus, it is apparent from Fig. 2 that the chamber shield 106 together with the clamp ring 154 protects the interior of the vacuum chamber 102 from the deposition materials being deposited on the substrate 112 in the plasma chamber 100. As described more fully in the aforementioned copending application, Serial No. , entitled A METHOD FOR PROVIDING FULL-FACE HIGH DENSITY PLASMA PHYSICAL VAPOR DEPOSITION, filed 1996 (Attorney Docket # 1402/PVD/DV), the clamp ring may be eliminated. The chamber shield 106 also is preferably formed of (diamagnetic) titanium or (non-ferromagnetic) stainless steel or (non-magnetic) nickel, like the dark space shield 130.

The vacuum chamber wall 108 has an upper annular flange 150. The plasma chamber 100 is supported by an adapter ring assembly 152 which engages the vacuum chamber wall flange 150. The chamber shield 106 has a horizontally extending outer flange member 160 which is fastened by a plurality of fastener screws (not shown) to a horizontally extending flange member 162 of the adapter ring assembly 152. The chamber shield 106 is grounded to the system ground through the adapter ring assembly 152.

The dark space shield 130 also has an upper flange 170 which is fastened to the horizontal flange 162 of the adapter ring assembly 152. The dark space shield 130, like the chamber shield 106, is grounded through the adapter ring assembly 152.

The magnetron-free target 110 is generally disk-shaped and is also supported by the adapter ring assembly 152. However, the magnetron-free target 110 is negatively biased and therefore should be insulated from the adapter ring assembly 152 which is grounded. Accordingly, seated in a channel 176 formed in the underside of the magnetron-free target 110 is a ceramic insulation ring assembly 172 which is also seated in a corresponding channel 174 in the upper side of the adapter ring assembly 152. The insulation ring assembly 172, which may be made of a variety of insulative materials including ceramics, spaces the magnetron-free target 110 from the adapter ring assembly 152 so that the magnetron-free target 110 may be adequately negatively biased. The target, adapter and ceramic ring assemblies are provided with O-ring sealing surfaces 178 to provide a vacuum tight assembly from the vacuum chamber flange 150 to the magnetron-free target 110.

In accordance with one aspect of the present invention, there is no rotating magnetron or other magnet assembly provided above the target 110. A magnetron produces magnetic fields which sweep over the face of a target for the purpose of producing ions to sputter the target. However, it has been found that such magnetron produced magnetic fields distort the energy and momentum distributions of the flux of plasma ions being attracted to the target.

An advantage of not using a magnetron for sputtering is that the absence of substantially any magnetron magnetic fields in the plasma generation region of the plasma chamber 100 allows the DC power applied to the magnetron-free target 110 to be reduced in comparison with the case where magnetron sputtering is used. For example, without magnetron magnetic fields in the plasma generation region of the plasma chamber 100, it has been found that the DC power applied to the magnetron-free target 110 may be in a range of about 2.5 kW to about 3.3 kW, whereas in the case with magnetron sputtering, the DC power applied to the target is preferably in a range of 3.5 kW to 5.0 kW. The absence of the distorting magnetic fields used in magnetron sputtering also leads to more uniform erosion of the magnetron-free target 110, which improves the deposition uniformity of the target material on the substrate 112 when compared to the case where magnetron sputtering is used. For example, without magnetron magnetic fields in the plasma generation region of the plasma chamber 100, the degree of non-uniformity of the deposited material (the deviation from uniformity measured at a number of points, such as 81 points, within a probe area) has been found to be about 10% or less, whereas in the case of magnetron sputtering, the degree of non-uniformity can be 20% or more.

Without magnetron magnetic fields in the plasma generation region of the plasma chamber 100, the target material ion momentum and energy distributions in the high density plasma are also very different, and the flux of target material ions tends to be more perpendicular to the substrate 112 than in the case where magnetron sputtering is used. By providing a magnetron-free target 110 adjacent the plasma generation region that is substantially free of any magnetron magnetic fields that would otherwise produce magnetron sputtering from the magnetron-free target 110 onto the substrate 112, there is substantially no magnetic distortion of either the high density plasma or the flux of target material ions.

The absence of substantially any magnetron magnetic fields in the plasma generation region of the plasma chamber 100 also enables the effective electron density of the high density plasma to be higher than in the case where magnetron sputtering is used. Without magnetron magnetic fields in the plasma generation region of the plasma chamber 100, typical electron densities in the high density plasma are on the order of about 10¹² cm⁻³, about 1.5 to 2.0 times higher than in the case where magnetron sputtering is used. Higher electron densities in the high density plasma may lead to a higher degree of ionization of the sputtered target material in the high density plasma. For example, the degree of ionization of the sputtered target material in the high density plasma in the absence of magnetron sputtering may be typically about 80%-90%. Typical pressures in the high density plasma are in the range of about 10 mTorr to about 50 mTorr, and preferably are about 30 mTorr. The mean free path of the sputtered target material in the high density plasma is typically relatively short so that there are about 1000 collisions in the distance from the magnetron-free target 110 to the substrate 112, which distance is typically about 125 mm to about 150 mm.

The deposition rate of material deposited from the magnetron-free target 110 onto the substrate 112 in the absence of magnetron sputtering can be substantially the same or higher than in the case with magnetron sputtering, even though the lowered DC power applied to the magnetron-free target 110 leads to less sputtering per ion, since the higher density plasma leads to more ions sputtering material from the magnetron-free target 110. For example, without magnetron sputtering, the deposition rate of material deposited from the magnetron-free target 110 onto the substrate 112 may be about 1280 Å/min, with a DC power applied to the magnetron-free target 110 of about 3.5 kW and an RF power applied to the coil 104 of about 3.0 kW, whereas in the case of magnetron sputtering, the deposition rate is 1200 Å/min, with an applied DC power of 5.0 kW and an applied RF power of 1.5 kW. Increased RF power applied to the coil 104 in the absence of substantially any magnetron sputtering is used to induce a higher density plasma, which enables substantially the same or higher deposition rate and improves the deposition uniformity of the target material on the substrate 112 when compared to the case where magnetron sputtering is used.

All of the above-mentioned advantages of eliminating magnetron sputtering lead to enhanced uniformity of deposition of material from the magnetron-free target 110 onto the substrate 112, and to greater effective deposition of material from the magnetron-free target 110 onto the fine features and structures of the substrate 112, particularly those with very high aspect ratios, such as deep, narrow trenches, vias and contact holes. The greater effective deposition enables better overall conformal coverage.

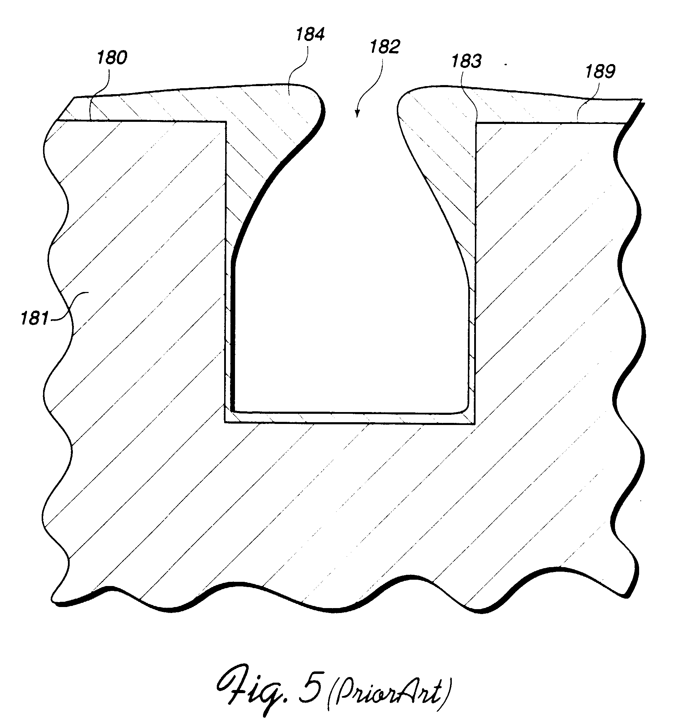

For example, when magnetron sputtering is used to deposit a layer 189 of titanium on the surface 180 of a substrate 181 and in a contact hole 182, as shown in prior art Fig. 5, the step coverage (the ratio of the thickness of the titanium deposited at the bottom of the contact hole to the thickness of the titanium deposited on the surface of the substrate) is in a range of 40% to 50%, and the neck 183 of the contact hole 182 has an overhang 184 of crystallized titanium. The sidewall coverage (the ratio of the thickness of the titanium deposited at the bottom of the sidewall of the contact hole to the thickness of the titanium deposited at the top of the sidewall of the contact hole) is very small because of the overhang 184 of crystallized titanium at the neck 183 of the contact hole 182.

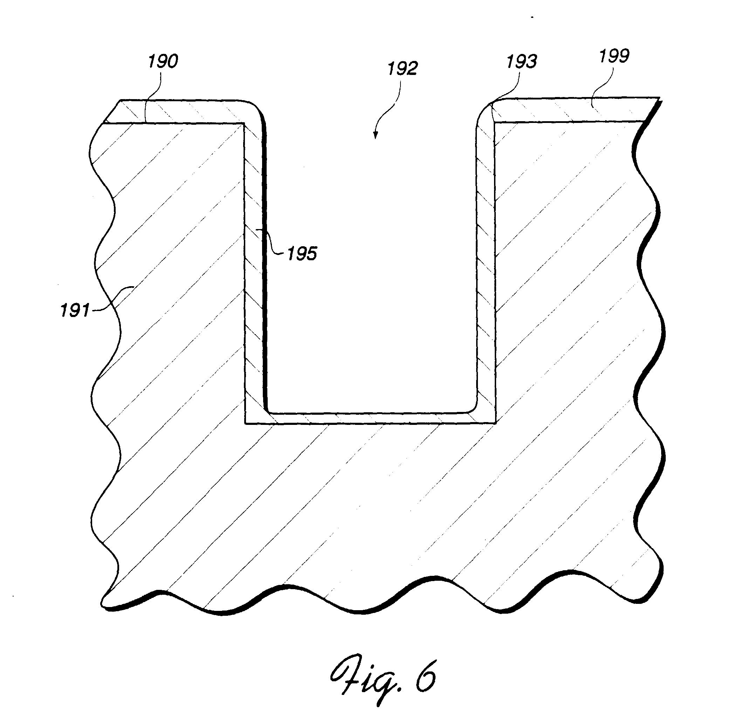

By way of contrast, in an embodiment of the present invention, when a layer 199 of titanium is deposited on the surface 190 of a substrate 191 and in a contact hole 192 without using magnetron sputtering, as shown in Fig. 6, the step coverage is in a range of about 40% to about 50%, and the neck 193 of the contact hole 192 is substantially smoother than the neck 183 of the contact hole 182 shown in Fig. 5, substantially without any structure corresponding to the overhang 184 of crystallized titanium shown in Fig. 5. The sidewall coverage shown in Fig. 6 is much greater than, and much improved over, the sidewall coverage shown in prior art Fig. 5. The target material titanium ion momentum and energy distributions in the high density plasma and enhanced deposition enabled by eliminating magnetron sputtering are believed to produce a more amorphous structure of the deposited titanium, and fewer crystallized overhangs, than when magnetron sputtering is used. The smoother titanium sidewall 195 of the contact hole 192 shown in Fig. 6 also enables improved "wetting" by heated aluminum flowing into the contact hole 192 as compared to heated aluminum flowing into the contact hole 182 shown in Fig. 5 and as compared to heated aluminum flowing directly into a contact hole formed in a silicon semiconductor substrate without any intervening layer of titanium deposited thereon.

The coil 104 of the illustrated embodiment is made of 2 inch by 1/16 inch heavy-duty bead-blasted solid high-purity (preferably 99.995% pure) titanium or copper ribbon formed into a single turn helical coil having a diameter of about 11.5 inches. However, other highly conductive materials and shapes may be utilized depending upon the material being sputtered and other factors. For example, the ribbon may be as thick as 1/8 inch. Also, if the material to be sputtered is aluminum, both the target and the coil should be made of high-purity aluminum. In addition to the ribbon shape illustrated, hollow tubing may be utilized, particularly if water cooling is desired.

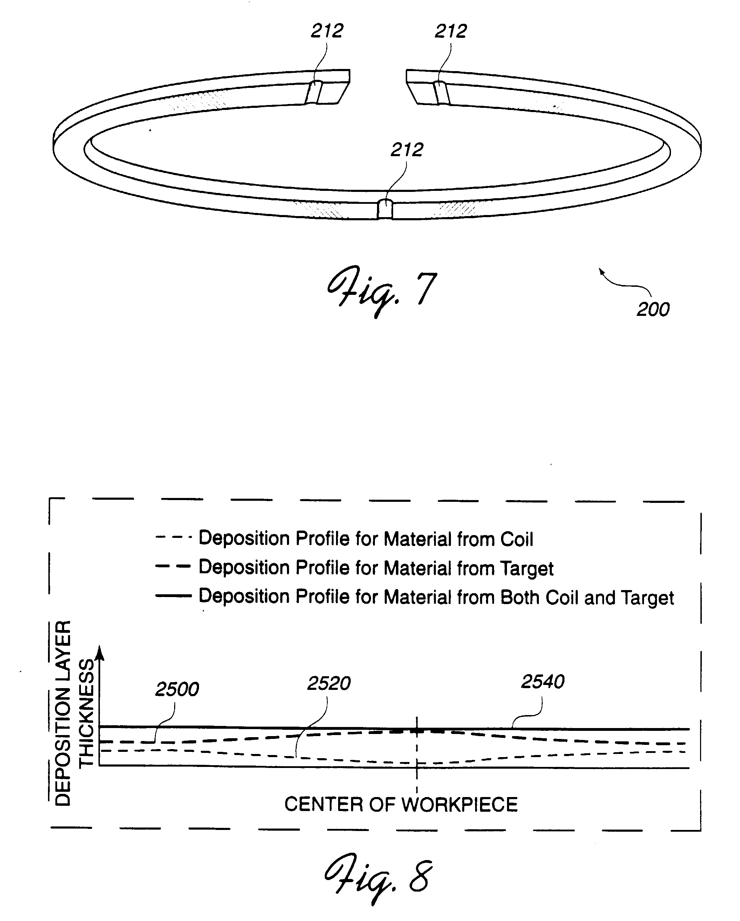

Still further, instead of the ribbon shape illustrated, the coil may be implemented by a flat, open-ended annular ring 200 such as that illustrated in Fig. 7, as described in copending application Serial No. 08/644,096, entitled COILS FOR GENERATING A PLASMA AND FOR SPUTTERING, filed May 10, 1996 (Attorney Docket # 1390/PVD/DV) and assigned to the assignee of the present application, which application is incorporated herein by reference in its entirety. Grooves 212 on the underside of the annular ring 200 facilitate the support of the annular ring 200 from a chamber shield wall, such as the chamber wall shield 140 shown in Fig. 2. Such an arrangement is particularly advantageous for multiple turn coils. The advantage of a multiple turn coil is that the required current levels can be substantially reduced for a given RF power level. However, multiple turn coils tend to be more complicated and hence more costly and difficult to clean as compared to single turn coils. For example, a three turn helical coil of titanium and its associated supporting structure could be quite expensive. Single turn coils, on the other hand, generally have a much simpler design, are easier to manufacture, hence cheaper, and provide less material to sputter onto a workpiece and also provide less surface area on which particulates of deposited material may form and then subsequently flake off, contaminating the workpiece.

Each of the embodiments discussed above utilized a single coil 104 in the plasma chamber 100. It should be recognized that the present invention is applicable to plasma chambers having more than one RF powered coil and to RF powered shields. For example, the present invention may be applied to multiple coil chambers for launching helicon waves of the type described in copending application Serial No. 08/559,345, filed November 15, 1995 for METHOD AND APPARATUS FOR LAUNCHING A HELICON WAVE IN A PLASMA which is assigned to the assignee of the present application and is incorporated herein by reference.

The appropriate RF generators and matching circuits are components well known to those skilled in the art. For example, an RF generator such as the ENI Genesis series which has the capability to "frequency hunt" for the best frequency match with the matching circuit and antenna is suitable. The frequency of the generator for generating the RF power to the coil 104 is preferably 2 MHz but it is anticipated that the range can vary from, for example, 1 MHz to 4 MHz. An RF power setting of 3.0 kW is preferred but a range of 1.5-4.5 kW is satisfactory. In addition, a DC power setting for biasing the magnetron-free target 110 of 3.5 kW is preferred but a range of 2.5-3.5 kW and a pedestal 114 bias voltage of -30 volts DC is satisfactory.

In the illustrated embodiments above, the chamber shield 106 has a diameter of 16", but it is anticipated that satisfactory results can be obtained with a diameter in the range of 6"-25". The shields may be fabricated from a variety of materials including insulative materials such as ceramics or quartz. However, the shield and all metal surfaces likely to be coated with the target material are preferably made of a material such as stainless steel or copper, unless made of the same material as the sputtered target material. The material of the structure which will be coated should have a coefficient of thermal expansion which closely matches that of the material being sputtered to reduce flaking of sputtered material from the shield or other structure onto the wafer. In addition, the material to be coated should have good adhesion to the sputtered material. Thus for example if the deposited material is titanium, the preferred metal of the shields, brackets and other structures likely to be coated is bead-blasted titanium. Any surfaces which are more likely to sputter, such as the end caps of the coil and feedthrough standoffs, would preferably be made of the same type of material as the target, such as high-purity, bead-blasted titanium, for example. Of course, if the material to be deposited is a material other than titanium, the preferred metal is the deposited material, stainless steel, for example. Adherence can also be improved by coating the structures with molybdenum prior to sputtering the target. However, it is preferred that the coil (or any other surface likely to sputter) not be coated with molybdenum or other materials since the molybdenum can contaminate the workpiece if sputtered from the coil.

The wafer to target spacing is preferably about 140 mm (about 5.5"), but can range from about 1.5" to 8". For this wafer to target spacing, satisfactory stepped wafer bottom coverage has been achieved with a coil diameter of 11.5 inches spaced from the target by a distance of 1.9 inches. It has been found that increasing the diameter of the coil which moves the coil away from the workpiece edge has an adverse effect on bottom coverage. On the other hand, decreasing the coil diameter to move the coil closer to the wafer edge can adversely effect layer uniformity.

Deposition uniformity also appears to be a function of coil spacing from the target. As previously mentioned, a spacing of 1.9 inches between the coil and target has been found satisfactory for a target to wafer spacing of 140 mm. Moving the coil vertically either toward or away from the target (or wafer) can adversely effect deposition layer uniformity.

A variety of precursor gases may be utilized to generate the plasma including Ar, H₂, O₂ or reactive gases such as NF₃, CF₄ and many others. Various precursor gas pressures are suitable including pressures of 0.1 - 50 mTorr. For ionized PVD, a pressure between 10 mTorr and 50 mTorr, preferably 30 mTorr, enables the best ionization of sputtered material.

In the embodiments illustrated above, the magnetron-free target 110 was shown having a flat surface facing the substrate 112. Other design shapes for the magnetron-free target 110 are, of course, possible, and may lead to different deposition profiles for the material deposited from the target onto the substrate. For example, a secondary annular target (of titanium, aluminum or other suitable materials) may be positioned around the periphery of the substrate, to supplement the material being sputtered from a primary planar target onto the substrate, with the primary planar target positioned above the substrate. In order to accommodate the coil 104 to facilitate ionization of the plasma, it has been found beneficial to space the magnetron-free target 110 from the surface of the substrate 112. However, this increased spacing between the target and the substrate can adversely impact the uniformity of the material being deposited from the target. As indicated at 2500 in Fig. 8, such nonuniformity typically exhibits itself as a thickening of the deposited material toward the center of the substrate with a consequent thinning of the deposited material toward the edges of the substrate. This nonuniformity can be effectively compensated by sputtering deposition material not only from the magnetron-free target 110 above the substrate 112 but also from the coil 104 (or the secondary magnetron-free target) encircling the edges of the substrate 112. Because the edges of the substrate 112 are closer to the coil 104 (or the secondary magnetron-free target) than is the center of the substrate 112, it has been found that the material sputtered from the coil 104 (or the secondary magnetron-free target) tends to deposit more thickly toward the edges of the substrate 112 than the center, as indicated at 2520 in Fig. 8. This is of course the reverse of the deposition pattern of material from the magnetron-free target 110. By appropriately adjusting the ratio of the DC and/or the RF power levels applied to the coil 104 (or the DC and/or the RF power levels applied to the secondary magnetron-free target) to the DC power level of the bias applied to the magnetron-free target 110, it has been found that the deposition level of the material being sputtered from the coil 104 (or the secondary magnetron-free target) can be selected in such a manner as to compensate substantially for the nonuniformity of the deposition profile of the material from the magnetron-free target 110 such that the overall deposition profile of the layer from both sources of sputtered material, as indicated by the deposition profile 2540 in Fig. 8, can be substantially more uniform than that which has often been obtained from the magnetron-free target 110 alone. It is preferred that the coil 104 (or the secondary magnetron-free target) supply sufficient sputtered material such that the material sputtered from the coil 104 (or the secondary magnetron-free target) be deposited at a rate of at least 50 A per minute as measured at the edge of the substrate 112 in addition to that material being sputtered from the magnetron-free target 110 and deposited on the substrate 112.

Another advantage of not using any magnetron sputtering is that the absence of any magnetron magnets around the plasma chamber 100 makes for a less complicated overall structure than when magnetron sputtering is used. Similarly, the absence of any magnetron magnets around the plasma chamber 100 eliminates the need for any complicated mechanism to provide for the mechanical movement of any magnetron magnets, making for simpler mechanics than when magnetron sputtering is used.

It will, of course, be understood that modifications of the present invention, in its various aspects, will be apparent to those skilled in the art, some being apparent only after study, others being matters of routine mechanical and electronic design. Other embodiments are also possible, their specific designs depending upon the particular application. As such, the scope of the invention should not be limited by the particular embodiments herein described but should be defined only by the appended claims and equivalents thereof.

## Claims

1. An apparatus for energizing a plasma within a semiconductor fabrication system to sputter material onto a workpiece, the apparatus comprising:
a semiconductor fabrication chamber having a magnetron-free target and a plasma generation region adjacent to said target; and
a coil carried by said chamber and positioned to couple energy into said plasma generation region, to produce ions to strike said target, wherein said target is substantially free of any magnetron magnetic fields capable of producing magnetron sputtering from said target onto said workpiece.

2. The apparatus of claim 1 including a target including titanium, wherein said coil includes titanium.

3. The apparatus of claim 1 including a target including aluminum, wherein said coil includes aluminum.

4. An apparatus for energizing a plasma within a semiconductor fabrication system to sputter material onto a workpiece, the apparatus comprising:
a semiconductor fabrication chamber having a magnetron-free target and a plasma generation region adjacent to said target; and
a coil carried by said chamber and positioned to couple energy into said plasma generation region, to produce ions to strike said target, wherein substantially all of said ions striking said target are produced by said energy coupled into said plasma generation region by said coil.

5. The apparatus of claim 4 including a target including titanium, wherein said coil includes titanium.

6. The apparatus of claim 4 including a target including aluminum, wherein said coil includes aluminum.

7. An apparatus for energizing a plasma within a semiconductor fabrication system to sputter material onto a workpiece, the apparatus comprising:
a semiconductor fabrication chamber having magnetron-free target made of a first material and a plasma generation region adjacent to said target; and
a coil carried by said chamber and formed of said first material as said target and positioned to couple energy into said plasma generation region, to produce ions to strike said target, wherein said target is substantially free of any magnetron magnetic fields capable of producing magnetron sputtering from said target onto said workpiece, and wherein substantially all of said ions striking said target are produced by said energy coupled into said plasma generation region by said coil.

8. The apparatus of claim 7 including:
a first source for applying a DC bias to said target;
a second source for applying a DC bias to said workpiece; and
an RF generator for applying RF power to said coil.

9. The apparatus of claim 7 including:
a first source for applying a DC bias to said target;
a second source for applying a DC bias to said workpiece;
a first RF generator for applying a varying bias to said workpiece; and
a second RF generator for applying RF power to said coil.

10. The apparatus of claim 7 including:
a first source for applying a DC bias to said target;
a second source for applying a DC bias to said workpiece;
a third source for applying a DC bias to said coil;
a first RF generator for applying a varying bias to said workpiece; and
a second RF generator for applying RF power to said coil.

11. The apparatus of claim 7 including:
a first source for applying a DC bias to said target;
a second source for applying a DC bias to said workpiece;
a third source for applying a DC bias to said coil; and
an RF generator for applying RF power to said coil.

12. An apparatus for energizing a plasma within a semiconductor fabrication system to sputter material onto a workpiece, the apparatus comprising:
a semiconductor fabrication chamber having a plasma generation region within said chamber;
a primary magnetron-free target carried by said chamber and positioned above said workpiece;
a secondary magnetron-free target carried by said chamber and formed of the same type of material as said primary target, said secondary target being positioned adjacent said workpiece to sputter said secondary target material onto said workpiece so that both said primary target material and said secondary target material are deposited on said workpiece to form a layer; and
a coil carried by said chamber and positioned to couple energy into said plasma generation region, to produce ions to strike said primary and secondary targets,
wherein said primary and secondary targets are substantially free of any magnetron magnetic fields capable of producing magnetron sputtering from said primary and secondary targets onto said workpiece, and wherein substantially all of said ions striking said primary and secondary targets are produced by said energy coupled into said plasma generation region by said coil.

13. A method of depositing material on a workpiece, the method comprising
coupling RF energy from a coil into a plasma to produce ions to strike a magnetron-free target positioned above said workpiece; and
sputtering target material onto said workpiece from said magnetron-free target.

14. The method of claim 13 including varying a biasing of said workpiece.

15. The method of claim 13 wherein said coil includes a coil material, and said target material and said coil material are the same type of material.

16. The method of claim 15 including biasing said coil.

17. A method of depositing material on a workpiece, the method comprising
coupling RF energy from a coil into a plasma to produce ions to strike a primary magnetron-free target positioned above said workpiece and a secondary magnetron-free target positioned adjacent said workpiece; and
sputtering primary target material onto said workpiece from said primary target and secondary target material onto said workpiece from said secondary target.

18. The method of claim 17 including varying a biasing of said workpiece.

19. The method of claim 17 wherein said coil includes a coil material, and wherein said primary and secondary target materials and said coil material are the same type of material.

20. The method of claim 19 including biasing said coil.
